Europäisches Patentamt

(19) European Patent Office

Office européen des brevets

(11) Veröffentlichungsnummer: **0 090 921**
**B1**

(12) EUROPÄISCHE PATENTSCHRIFT

(45) Veröffentlichungstag der Patentschrift:
30.04.86

(51) Int. Cl.⁴: **E 05 C 19/06, F 16 B 17/00**

(21) Anmeldenummer: 83101093.9

(22) Anmeldetag: 05.02.83

(54) Anordnung zum beschädigungsfreien Lösen einer zwischen zwei zusammengefügten Gehäuseteilen wirksamen, an sich nicht lösbaren Schnappverbindung.

(30) Priorität: 02.04.82 DE 3212255

(43) Veröffentlichungstag der Anmeldung:
12.10.83 Patentblatt 83/41

(45) Bekanntmachung des Hinweises auf die Patenterteilung:
30.04.86 Patentblatt 86/18

(84) Benannte Vertragsstaaten:
DE FR GB IT

(56) Entgegenhaltungen:
DE - B - 2 618 674
DE - U - 6 604 563
FR - A - 2 306 359

(73) Patentinhaber: Mannesmann Kienzle GmbH,
Heinrich-Hertz-Strasse, D-7730 Villingen-Schwenningen
(DE)

(72) Erfinder: Donner, Bernd, Augenmoosstrasse 10,
D-7730 Villingen-Schwenningen (DE)

## Beschreibung

Die Erfindung betrifft eine Anordnung zum beschädigungsfreien Lösen einer zwischen zwei zusammengefügten Gehäuseteilen wirksamen, an sich nicht lösbaren Schnappverbindung mit an dem einen Gehäuseteil im wesentlichen freistehend angeformten Schnapphaken, von denen jeweils jeder als ein quer zur Fügerichtung der beiden Gehäuseteile federungsfähiger, an seinem freien Ende einen Riegel tragender Arm ausgebildet ist, mit den Riegeln zugeordneten Hinterschnitten, welche in dem anderen, die Schnapphaken übergreifenden und wenigstens teilweise eine Außenwand des Gehäuses bildenden Gehäuseteil ausgeformt sind sowie mit in dem die Schnapphaken tragenden Gehäuseteil befindlichen, in Fügerichtung der beiden Gehäuseteile von außen zugänglichen Entriegelungsöffnungen.

Die Anwendung von Schnappverbindungen zwischen aus Kunststoff gefertigten Bauelementen, Gehäuseteilen und dergl. ist, wenn ausreichend hohe Stückzahlen gegeben sind, allgemein üblich, da die Elemente solcher Verbindungen an den zu verbindenden Teilen, abgesehen von der möglichen Ausführungsvielfalt, spritzgußtechnisch ausbildbar sind und die Montage in den meisten Anwendungsfällen werkzeuglos durchgeführt werden kann. Funktionell können derartige Schnappverbindungen als nicht bzw. als nicht ohne Beschädigung der miteinander verbundenen Teile lösbare, sozusagen Einwegverbindungen oder als lösbare Verbindungen ausgebildet sein, wobei im letzteren Falle die Schnappelemente nach dem Zusammenfügen der zu verbindenden Teile zugänglich sind oder Vorkehrungen getroffen sind, die das Lösen solcher Schnappverbindungen erleichtern.

Da ebenfalls, bedingt durch die Möglichkeit der Kunststoff-spritzgußtechnik, die zu verbindenden Teile mehr und mehr als relativ hochwertige Mehrfunktionsteile ausgebildet sind und insbesondere bei Meßgeräten mit Anzeige- oder Registrierfunktionen Wartungs- und Umrüsteingriffe möglich sein müssen, sind, um bei derartigen Eingriffen Beschädigungen zu vermeiden und um die Wiederverwendbarkeit beispielsweise eines Frontrahmens oder eines Montagebodens zu gewährleisten, die verwendeten Schnappverbindungen als lösbare Verbindungen auszubilden.

Dem steht gegenüber, daß insbesondere für die Gehäuseteile derartiger Geräte im allgemeinen nicht nur hohe Dimensionsstabilität gefordert wird, sondern daß, da diese Geräte vielfach hohen thermischen und Schwingungsbelastungen ausgesetzt sind, die Schnappverbindungen für große Haltekräfte dimensioniert werden müssen und somit beispielsweise glasfaserverstärkte Kunststoffe Anwendung finden. Das heißt, daß nur mit begrenzten elastischen Eigenschaften gerechnet werden kann und beim Lösen derartiger Schnappverbindungen die Gefahr der Überdehnung der federnden Elemente gegeben ist. Hinzu kommt, daß zwischen miteinander verbundenen Gehäuseteilen im allgemeinen mehrere Schnappverbindungen wirksam sind, die, wenn die Gehäuseteile getrennt werden sollen, gleichzeitig entriegelt sein müssen, was beschädigungsfrei in vielen Fällen nur mit erheblicher Geschicklichkeit oder einem Sonderwerkzeug möglich ist.

Andererseits ist es bei den genannten Geräten nicht nur aus ästhetischen Gründen zweckmäßig, die Schnappelemente verdeckt anzuordnen, sondern auch aus Sicherheitsgründen zwingend erforderlich, die Schnappelemente weitgehend eingriffssicher, d.h. nicht ohne weiteres lösbar, zu gestalten und letztlich auch Maßnahmen zu treffen, mit denen ein unerlaubtes Lösen derartiger Schnappverbindungen nachgewiesen werden kann.

Das Prinzip einer lösbaren Schnappverbindung zeigt beispielsweise die DE-U-66 04 563. Der dort beschriebene Gegenstand sieht vor, daß zur Verbindung eines Metallstreifens mit einem Bauteil dieser in einen in dem Bauteil befindlichen Schlitz eingeführt wird, daß am Ende des Schlitzes ein Freiraum vorgesehen ist, der ein Aufspreizen von an dem Metallstreifen angebogenen, federnden Lappen ermöglicht und daß der Freiraum für das Einführen eines Werkzeuges, beispielsweise eines Schraubenziehers, zugänglich ist, mit dem die Lappen wieder in die Ebene des Metallstreifens gedrückt werden, um diesen aus dem Schlitz herausziehen zu können.

Mit der DE-U- 1 887 174 ist es bekannt geworden, zwei Gehäusehälften mittels Riegelverbindungen zusammenzufügen. Den Riegeln zugeordnete, von außen zugängliche Öffnungen erlauben ein Eingreifen mittels eines geeigneten Werkzeuges und ein Verschwenken der Riegel. Da das Gehäuse von mehreren Riegeln zusammengehalten wird, ist es erforderlich, beim Entriegeln des einen Riegels die Gehäusehälften zusätzlich auseinanderzuspreitzen, um zu vermeiden, daß vor dem Entriegeln des nächsten Riegels der erste wieder in Eingriff geht. Ein derart untechnisches und im allgemeinen nicht beschädigungsfreies Lösen von Schnappverbindungen ist für den geschilderten Anwendungszweck unbrauchbar.

Somit war der vorliegenden Erfindung die Aufgabe gestellt, eine Anordnung zu schaffen, die es gestattet, Gehäuseteile, die mittels an sich nicht lösbarer Schnappverbindungen zusammengefügt sind, ohne Beschädigungen auf relativ einfache Weise trennen zu können, wobei, um unerlaubtes Trennen nachweisbar zu machen, die Zugänge zu den federnden Elementen der Schnappverbindungen plombiert sein sollen.

Die Lösung dieser Aufgabe sieht vor, daß jeder Schnapphaken derart ausgebildet und angeordnet ist, daß zwischen dem übergreifenden, vorzugsweise die Außenwand des Gehäuses bildenden Gehäuseteil und dem Arm des Schnapphakens, ausgehend von der Entriegelungsöffnung, ein in Richtung des Riegels sich keilförmig verengender Freiraum gebildet ist, daß ein dem Freiraum angepaßter und durch die Entriegelungsöffnung in diesen einschiebbarer Keil vorgesehen ist und daß in einem der beiden Gehäuseteile ein die Bewegung des Keils in dem Freiraum begrenzender Anschlag ausgebildet ist.

Ein bevorzugtes Ausführungsbeispiel ist dadurch gekennzeichnet, daß der Keil als eine in die Entriegelungsöffnung ein-preßbare, die Entriegelungsöffnung schließende Plombe ausgebildet ist, daß an dem Keil wenigstens eine Zunge angeformt ist, daß zwischen dem Keil und der Zunge eine Sollbruchstelle ausgebildet ist und daß die Zunge, wenn der Keil in die Entriegelungsöffnung in dem die Schnapphaken tragenden Gehäuseteil eingepreßt ist, auf diesem Gehäuseteil vorzugsweise versenkt aufliegt.

Eine vorteilhafte Ausbildung der Erfindung besteht ferner darin, daß an dem die Schnapphaken tragenden Gehäuseteil eine umlaufende, das die Schnapphaken übergreifende Gehäuseteil zentrierende, im wesentlichen der Höhe der Schnapphaken entsprechende Wand ausgebildet ist und daß die zentrierende Wand im Bereich der Schnapphaken derart gestuft freigespart ist, daß die größere Weite der Freisparung der Entriegelungsöffnung zugekehrt ist.

Die Erfindung bietet, abgesehen davon, daß sie die gestellte Aufgabe zufriedenstellend löst, insbesondere daß mit an sich nicht lösbar ausgebildeten Schnappverbindungen ausgerüstete Gehäuseteile mit Sicherheit beschädigungsfrei getrennt werden können, den zusätzlichen Vorteil, daß die Handhabung beim Lösen mehrerer zwischen zwei Gehäuseteilen wirksamer Schnappverbindungen entscheidend vereinfacht, sozusagen systematisiert ist und hierzu keine Sonderwerkzeuge erforderlich sind.

Im folgenden sei die Erfindung anhand der beigefügten Zeichnungen näher erläutert. Es zeigen

FIG. 1 eine perspektivische Darstellung eines ersten Ausführungsbeispiels einer zwischen zwei Gehäuseteilen wirksamen, erfindungsgemäß angeordneten Schnappverbindung,

FIG. 2 einen Teilschnitt durch ein weiteres Ausführungsbeispiel im verriegelten Zustand der beiden Gehäuseteile,

FIG. 3 einen Teilschnitt des Ausführungsbeispieles ge-mäß FIG. 2 im entriegelten Zustand der beiden Gehäuseteile,

FIG. 4 einen Teilschnitt, der eine Variante der Gehäuseverbindung darstellt,

FIG. 5 eine Draufsicht auf erfindungsgemäß plombierte Schnappverbindungen eines Gehäuses.

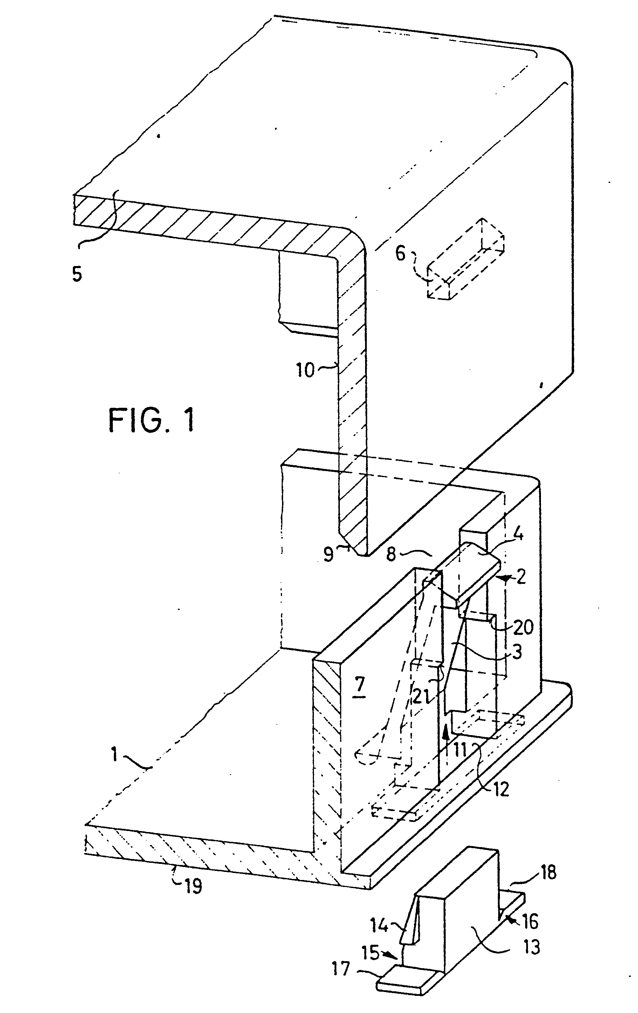

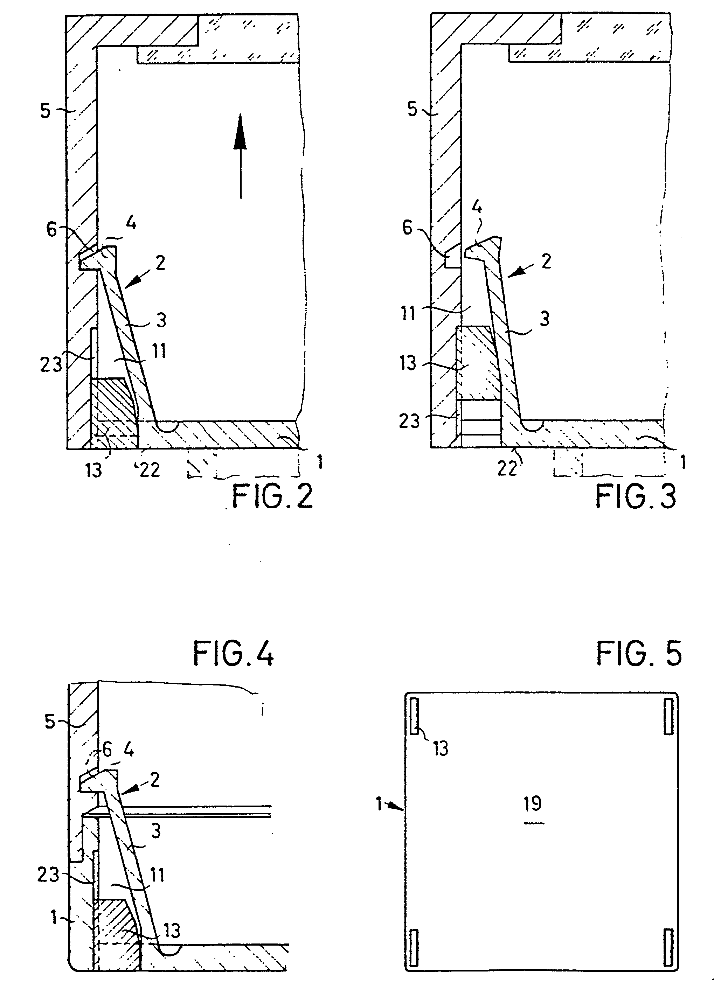

Wie die FIG. 1 zeigt, ist an einem ersten Gehäuseteil 1 ein Schnapphaken 2 angeformt, wobei das freie Ende des federnd ausgebildeten Armes 3 des Schnapphakens 2 die Form eines Riegels 4 aufweist. Dem Riegel 4 ist in einem weiteren Gehäuseteil 5, das beispielsweise als geschlossene Haube ausgebildet sein kann, ein geeigneter Hinterschnitt 6 zugeordnet. Der FIG. 1 ist ferner zu entnehmen, daß an dem Gehäuseteil 1, an dem der bzw. die Schnapphaken ausgebildet sind - wie FIG.5 zeigt könnten beispielsweise vier entsprechend platzierte Schnapphaken für das Verbinden der beiden Gehäuseteile 1 und 5 vorgesehen sein - eine umlaufende Wand 7 angeformt ist, in der eine dem Schnapphaken 2 zugeordnete Freisparung 8 vorgesehen ist. Die Wand 7 dient in diesem Falle dem Zentrieren des Gehäuseteils 5 am Gehäuseteil 1, womit ein Überdehnen des Schnapphakens 2 beim Zusammenfügen der beiden Gehäuseteile 1 und 5 vermieden wird. Eine am Gehäuseteil 5 ausgebildete, schräge Fläche 9 erleichtert beim Zusammenfügen ein Aufgleiten des Riegels 4 auf die Innenfläche 10 des Gehäuseteils 5.

Wie die FIG. 1 weiter zeigt, ergibt sich, wenn die Gehäuseteile 1 und 5 zusammengefügt sind, zwischen dem Arm 3 des Schnapphakens 2, der Innenfläche 10 des übergreifenden Gehäuseteiles 5 und den verschiedenen, nicht näher bezeichneten Stirnflächen der in der Wand 7 ausgebildeten Freisparung 8 ein sich in Richtung des Riegels 4 keilförmig verengender Freiraum 11, der durch eine Öffnung, die im folgenden als Entriegelungsöffnung 12 bezeichnet sein soll, zugänglich ist. Ein den Freiraum 11 nur teilweise ausfüllender Keil 13, der in die Entriegelungsöffnung 12 einsetzbar ist, vorzugsweise eingepreßt wird, dient einerseits dem Verschließen der Entriegelungsöffnung 12, andererseits, indem der Keil 13 innerhalb des Feiraumes 11 in Richtung des Riegels 4 verschoben wird, dem Entriegeln des Schnapphakens 2. Vorzugsweise ist der Keil 13 mit Rastnasen, von denen eine - 14 - in FIG. 1 gezeigt ist, versehen, wodurch ein Ausheben des Keils 13 aus der Entriegelungsöffnung 12 verhindert wird. Ferner sind an dem Keil 13 unter Zwischenschaltung von Sollbruchstellen 15 und 16 Zungen 17 und 18 angeformt, die beim Einschieben des Keils 13 in den Freiraum 11 abbrechen, womit die beabsichtigte Plombierfunktion realisiert ist. Wie aus der FIG. 1 außerdem ersichtlich ist, können im Gehäuseteil 1 geeignete, den Zungen 17 und 18 zugeordnete Senkungen vorgesehen sein, um den Keil 13 ebenflächig mit der Gehäusefläche 19 anordnen zu können.

Selbstverständlich ist es nicht zwingend erforderlich, den Keil 13 in das Gehäuseteil 1 einzupressen, er kann beispielsweise auch als ein erst beim Trennen der beiden Gehäuseteile 1 und 5 in den Freiraum 11 einführbares Werkzeug Anwendung finden. Entscheidend ist, daß dem Keil 13, um dessen Funktion einer Überdehnsicherung bezüglich des Schnapphakens 2 gerecht zu werden, ein geeigneter Anschlag zugeordnet ist. Beim Ausführungsbeispiel gemäß FIG. 1 ist zu diesem Zwecke die Freisparung 8 in der Wand 7 gestuft ausgebildet, d.h. die Stirnflächen 20 und 21 zwischen dem engeren und dem weiteren Teil der Freisparung 8 dienen dem Keil 13 als Anschlagflächen und verhindern ein weiteres Einschieben des Keils 13 in den Freiraum 11 und somit ein Überdehnen des Schnapphakens 2.

Bei dem Ausführungsbeispiel gemäß den FIG. 2 und 3 stellt das Gehäuseteil 5 beispielsweise den runden, quadratischen oder rechteckigen Frontring oder Frontrahmen eines anzeigenden Meßgerätes dar, welcher üblicherweise durch einen nicht dargestellten Federring bzw. federnden Dichtring in Pfeilrichtung unter Zug steht. Das Gehäuseteil 1, an dem mehrere Schnapphaken 2 ausgebildet sind, kann als Montageboden oder, wie strichpunktiert angedeutet, als topfförmiges Gehäuseteil ausgebildet sein, wobei im letzteren Falle die Ansatzfläche 22 in der Einbauebene des Meßgerätes liegen kann bzw. als Anschlagfläche gegenüber einem weiteren, nicht dargestellten Gehäuseteil dient. Bei diesem Ausführungsbeispiel ist der Keil 13 in einer in ihrer Tiefe begrenzten Nut im Gehäuse-

**Patentansprüche:**

1. Anordnung zum beschädigungsfreien Lösen einer zwischen zwei zusammengefügten Gehäuseteilen (1 und 5) wirksamen, an sich nicht lösbaren Schnappverbindung mit an dem einen Gehäuseteil (1) im wesentlichen freistehend angeformten Schnapphaken (2), von denen jeweils jeder als ein quer zur Fügerichtung der beiden Gehäuseteile (1 und 5) federungsfähiger, an seinem freien Ende einen Riegel (4) tragender Arm (3) ausgebildet ist, mit den Riegeln (4) zugeordneten Hinterschnitte (6), welche in dem anderen, die Schnapphaken (2) übergreifenden und wenigstens teilweise eine Außenwand des Gehäuses bildenden Gehäuseteil (5) ausgeformt sind sowie mit in dem die Schnapphaken tragenden Gehäuseteil befindlichen, in Fügerichtung der beiden Gehäuseteile von außen zugänglichen Entriegelungsöffnungen (12), dadurch gekennzeichnet, daß jeder Schnapphaken (2) derart ausgebildet und angeordnet ist, daß zwischen dem übergreifenden, vorzugsweise die Außenwand des Gehäuses bildenden Gehäuseteil (5) und dem Arm des Schnapphakens (2), ausgehend von der Entriegelungsöffnung (12), ein in Richtung des Riegels (4) sich keilförmig verengender Freiraum (11) gebildet ist, daß ein dem Freiraum (11) angepaßter und durch die Entriegelungsöffnung (12) in diesen einschiebbarer Keil (13) vorgesehen ist und daß in einem der beiden Gehäuseteile (1, 5) ein die Bewegung des Keils (13) in dem Freiraum (11) begrenzender Anschlag (20, 21 oder 23) ausgebildet ist.

2. Anordnung nach Anspruch 1, dadurch gekennzeichnet, daß der Keil (13) als eine in die Entriegelungsöffnung (12) einpreßbare, die Entriegelungsöffnung (12) schließende Plombe ausgebildet ist.

3. Anordnung nach Anspruch 1, dadurch gekennzeichnet, daß an dem Keil (13) wenigstens eine Zunge (17) angeformt ist, daß zwischen dem Keil (13) und der Zunge (17) eine Sollbruchstelle (15) ausgebildet ist und daß die Zunge (17), wenn der Keil (13) in die Entriegelungsöffnung (12) in dem die Schnapphaken (2) tragenden Gehäuseteil (1) eingepreßt ist, auf diesem Gehäuseteil (1) vorzugsweise versenkt aufliegt.

4. Anordnung nach Anspruch 1, dadurch gekennzeichnet, daß dem Keil (13) in der dem Schnapphaken (2) gegenüberliegenden Außenwand des Gehäuses eine in ihrer Tiefe begrenzte Führungsnut (23) zugeordnet ist.

5. Anordnung nach Anspruch 1, dadurch gekennzeichnet, daß an dem die Schnapphaken (2) tragenden Gehäuseteil (1) eine umlaufende, das die Schnapphaken (2) übergreifende Gehäuseteil (5) zentrierende, im wesentlichen der Höhe der Schnapphaken (2) entsprechende Wand (7) ausgebildet ist und daß die zentrierende Wand (7) im Bereich der Schnapphaken (2) derart gestuft freigespart ist, daß die größere Weite der Freisparung (8) der Entriegelungsöffnung (12) zugekehrt ist.

**Claims**

Arrangement for releasing without destroying a normally unreleasable snap connection between two housing parts (1 and 5) put together, wherein at one housing part (1) there are arranged essentially detached snapping hooks (27) connected thereto of which each is shaped as an arm (3) elastic transverse to the direction in which the two housing parts (1 and 2) are snapped together and bearing at the free end of its arm (3) a catch (4), the catches (4) having undercuts (6) with counteropenings as parts of the outside wall of the other housing part (5) which overlap the snapping hooks (2), and having in the housing part (1) bearing the snapping hooks (2) releasing openings (12) accessible from outside in the composing direction of the two housing parts, characterized in that each snapping hook (2) is of such shape and arrangement that between the overlapping housing part (5) preferably forming the peripheral wall of the housing and deriving from the releasing opening (12) and the hook (2) there is an opening (11) of wedge shape of narrowing form in the direction of the latch (4), and in that there is a wedge (13) adapted to the opening (11) and to be inserted into the releasing opening (12), and in that in one of the two housing parts (1 and 5) there is a stop (20, 21 or 23) limiting the movement of the wedge (13) in the opening (11).

2. Device according to Claim 1,
characterized in
that the wedge (13) is in the form of a seal to be pressed into the releasing opening (12) closing such releasing opening (12).

3. Device according to Claim 1,
characterized in
that at the wedge (13) there is at least one tongue (17), and in that between the wedge (13) and the tongue (17) there is a breaking point (15) and in
that the tongue (17) after the wedge (13) has been pressed into the releasing opening (12) at the housing part (1) bearing the snapping hooks (2) is arranged countersunk in such housing part (1).

4. Device according to Claim 1,
characterized in
that to the wedge (13) is attributed a guiding cut-out (23) in the peripheral wall of the housing limiting the movement of the wedge (13).

5. Device according to Claim 1,
characterized in
that at the housing part (1) bearing the snapping hooks (2) there is a running around wall (7) corresponding essentially in its hight to the snapping hooks (2) for centering the housing part (5) overlapping the snapping hooks (2) and
in that the running around centering wall (7) is recessed in steps in the range of the snapping hooks (2) so that the wider part of the recess (8) is turned towards the releasing opening (12).

**Revendications:**

1.- Dispositif pour le déverrouillage non destructif d'in assemblage à enclenchement efficace entre deux éléments de boîtier (1 et 5) assemblés, en soi non déverrouillables avec des crochets de blocage (2) moulés, pour l'essentiel, en porte-à-faux sur l'un des éléments de boîtier (1), dont chacun est réalisé sous forme d'un bras (3), élastique perpendiculairement au sens de l'assemblage des deux éléments de boîtier (1 et 5) et portant à son extrémité libre un verrou (4), avec des découpes de rétention (6) associées aux verrous (4), qui sont formées dans l'autre élément de boîtier (5) passant par dessus les crochets de blocage (2) et constituant, au moins partiellement, une paroi extérieure du boîtier, ainsi qu'avec des orifices de déverrouillage (12) ménagés dans l'élément de boîtier portant les crochets de blocage et étant accessibles de l'extérieur dans le sens de l'assemblage,
caractérisé par le fait
que chaque crochet de blocage (2) est réalisé et disposé de telle sorte qu'il se forme, entre l'élément de boîtier (5) recouvrant, constituant, de préférence, la paroi extérieure du boîtier et le bras du crochet de blocage (2) un espace libre (11) partant de l'orifice de déverrouillage (12) et s'aménuisant coniquement en direction du verrou (4), qu'il est prévu un coin (13) adapté à l'espace libre (11) et pouvant être introduit dans ce dernier, et que dans l'un des deux éléments de boîtier (1,5) est formée une butée (20, 21 ou 23) limitant le mouvement du coin (13) dans l'espace libre (11).

2.- Dispositif selon la revendication 1,
caractérisé par le fait
que le coin (13) est réalisé sous forme d'un plomb pouvant être pressé dans l'orifice de déverrouillage (12) et fermant ledit orifice de déverrouillage (12).

3. - Dispositif selon la revendication 1,
caractérisé par le fait
que sur le coin (13) est moulée-au moins une languette (17), qu'entre le coin (13) et la languette (17) est formé un point de rupture potentielle (15) et
que la languette (17), lorsque le coin (13) est pressé dans l'orifice de déverrouillage (12) dans l'élément de boîtier (1) portant les crochets de blocage (12), pose de préférence noyée sur cet élément de boîtier (1).

4. - Dispositif selon la revendication 1,
caractérisé par le fait
qu'au coin (13) est associée, dans la paroi extérieure du boîtier opposée au chrochet de blocage (2), une rainure de guidage (23) de profondeur limitée.

5. - Dispositif selon la revendication 1,
caractérisé par le fait
que sur l'élément de boîtier (1) portant les crochets de blocage (2) est formée une paroi (7) continue, centrant l'élément de boîtier (5) recouvrant les crochets de blocage (2) et correspondant, pour l'essentiel, à la hauteur des crochets de blocage (2) et
que la paroi de centrage (7) est évidée dans la région des crochets de blocage (2) avec une graduation telle que la plus grande largeur de l'évidement (8) est dirigée vers l'orifice de déverrouillage (12).

FIG. 1

FIG.2

FIG.3

FIG.4

FIG. 5